# EUROPEAN PATENT APPLICATION

(11) **EP 1 383 361 A2**
(43) Date of publication of application: **21.01.2004**
(21) Application number: 03016243.2
(22) Date of filing: 17.07.2003
(51) Int. Cl.: H05K 1/09, H05K 3/46, H01B 1/16

(54) **Copper paste, wiring board using the same, and production method of wiring board**

(30) Priority: 17.07.2002 JP 2002208319; 17.07.2002 JP 2002208321
(71) Applicant: NGK SPARK PLUG CO., LTD, Mizuho-ku Nagoya-shi Aichi (JP)
(72) Inventor: Sumi,Hiroshi, Mizuho-ku, Nagoya-shi, Aichi (JP); Mizutani, Hidetoshi, Mizuho-ku, Nagoya-shi, Aichi (JP); Sato, Manabu, Mizuho-ku, Nagoya-shi, Aichi (JP)
(74) Representative: Grünecker, Kinkeldey, Stockmair & Schwanhäusser Anwaltssozietät

(57) **Abstract**

A wiring board obtained by coating a copper paste on a ceramic green sheet and firing it to form a conductor layer (3) and an insulating layer (1,2), the copper paste comprising a copper powder, an organic vehicle and at least one (5) selected from the group consisting of: an SiO₂ particle having an average particle size of 50 nm or less; and a ceramic particle having an average particle size of 100 nm or less and non-vitrifiable after sintering.

## Description

### FIELD OF THE INVENTION

The present invention relates to a copper paste which is printed on a ceramic green sheet and simultaneously fired to form a circuit on a wiring board, and also relates to a wiring board using the copper paste. More specifically, the present invention relates to a copper paste and a wiring board using the copper paste, which are used for forming a high-frequency circuit and can realize reduced transmission loss and high-density packaging.

### BACKGROUND OF THE INVENTION

In recent years, accompanying the speeding up of information communication, the wiring board is used in a high frequency region of GHz band or more and demanded to be reduced in the transmission loss. To satisfy this requirement, the wiring board is produced by forming a conductor layer composed of a metal having a low conductor resistance and a low melting point, such as silver and copper, on a ceramic substrate having a relatively low dielectric constant. Also, with the progress of high-density packaging of a circuit, a wiring board having a conductor layer formed by using copper more excellent in the migration resistance than silver is demanded.

For producing a wiring board by using copper in the conductor layer, the organic components must be removed with good efficiency while preventing the oxidation of copper. As the method for realizing this, for example, firing in a wet nitrogen atmosphere (in a mixed atmosphere of water vapor and nitrogen) is known. First, a slurry is prepared using a ceramic raw material powder and an organic binder, a solvent or the like and formed into a ceramic green sheet by a sheet-forming method such as doctor blade method. Thereafter, a wiring pattern is printed on the ceramic green sheet by using a copper paste and dried. Subsequently, the ceramic green sheet is debindered at a temperature of hundreds of °C in a mixed atmosphere of water vapor and nitrogen gas to remove organic components contained in the copper paste and ceramic green sheet and then fired by elevating the temperature to nearly 1,000°C or more, thereby producing a wiring board.

In the wiring board, the firing temperature and the firing shrinkage timing at the firing step differ between the copper working out to a conductor layer and the ceramic substrate working out to an insulting layer and therefore, warping or waving is readily generated by firing. As a technique for improving this problem, a copper metallizing composition and a glass ceramic wiring board using the composition disclosed in JP-A-10-95686 (the term "JP-A" as used herein means an "unexamined published Japanese patent application") and a copper paste and a multilayer wiring board disclosed in JP-A-8-148783 are known.

According to the copper metallizing composition and the glass ceramic wiring board using the composition described in JP-A-10-95686, a copper paste having added thereto a specific inorganic material is used as the conductor layer and fired simultaneously with a glass ceramic porcelain, where the copper and the ceramic porcelain are approximated in the shrinkage initiation temperature by adding a specific inorganic material in the copper paste to thereby reduce the warping or waving of board after firing.

On the other hand, according to the copper paste and the production method of a multilayer wiring board disclosed in JP-A-8-148783, a copper paste containing from 1 to 4.5 parts by volume of an amorphous SiO₂-Al₂O₃-B₂O₃-RO (RO: alkaline earth metal oxide)-base glass powder is printed on a ceramic green sheet and fired, where the glass powder is added in a very small amount not to impair the plating property or soldering wettability and thereby a multilayer wiring board having a low conductor resistance and favored with high adhesion strength of the conductor layer is obtained, in addition, the copper is prevented from abrupt sintering at a low temperature and thereby the warping or waving of board after firing is reduced.

### SUMMARY OF THE INVENTION

However, with the recent progress of small-size wiring board, high-density packaging and high-frequency circuit signal, a plating treatment on a fine wiring pattern is required and therefore, more reduction in the coming up of glass to the conductor layer surface is demanded.

However, the copper metallizing composition and the glass ceramic wiring board using the composition described in JP-A-10-95686 have a problem in that since a specific inorganic material is added in the copper paste, the sintering of copper working out to a conductor layer is inhibited, as a result, dense sintering cannot be obtained and the conductor layer has a high resistance value. The copper metallizing composition and the glass ceramic wiring board using the composition described in JP-A-10-95686 have a problem in that since glass is contained in the ceramic porcelain, the glass comes up to the conductor layer surface and this makes it difficult to apply a high-precision plating on a fine wiring pattern.

Furthermore, the copper paste and the production method of a multilayer wiring board disclosed in JP-A-8-148783 have a problem in that since a glass flit is added to the copper paste, glass is liable to come up to the conductor layer surface and remain there after firing and the plating or soldering treatment becomes difficult.

An object of the present invention is to solve these problems and provide a copper paste, a wiring board using the copper paste and a production method of a wiring board, which can, in the wiring board using copper for the conductor layer, reduce the warping or waving due to firing, form a fine and dense wiring pattern on the wiring board surface, produce a wiring board excellent in the soldering property, and prevent the generation of plating failure ascribable to the coming up of glass to the conductor surface.

A first aspect of the invention created to achieve the above-described object is a copper paste comprising a copper powder, an organic vehicle and at least one of: an SiO₂ fine particle having an average particle size of 50 nm or less; and a ceramic particle having an average particle size of 100 nm or less and non-vitrifiable after sintering. The lower limit of the amount of the organic vehicle is not limited, but preferably, the copper paste comprises more than 20 parts by mass of the organic vehicle per 100 parts by mass of the copper powder. The upper limit of the amount of the organic vehicle is not limited, but preferably, the copper paste comprises no more than 40 parts by mass (more preferably, no more than 25 parts by mass) of the organic vehicle per 100 parts by mass of the copper powder.

A viscosity of the copper paste of the invention is not limited, but preferably no less than 30 poises (3 pa.sec) and lower than 5000 poises, more preferably from 300 to 1000 poises at 23°C.

When the copper paste comprising a copper powder, an organic vehicle and an SiO₂ fine particle having an average particle size of 50 nm or less is exposed in a wet nitrogen atmosphere (dew point:70°C), the sinterability of copper powder at the fining is improved and this provides an operational effect that a dense conductor layer having low resistance is formed, good plating or soldering property is ensured and a wiring board reduced in the warping or waving can be obtained.

The SiO₂ fine particle provides an operational effect of, in the debindering process performed in a temperature region lower that the firing temperature, heightening a temperature of the firing initiation of copper powder not to advance the densification and facilitating the escaping of organic components and also provides an operational effect of approximating the sintering initiation temperature of copper powder to the sintering initiation temperature of ceramic green sheet. On the contrary, in the subsequent firing process at a high temperature, the sintering of copper powder is accelerated to form a dense sintered body due to exposure to wet nitrogen in the debindering step and this provides an operational effect that the generation of warping or waving of the ceramic substrate is prevented. As such, the copper paste of the present invention can provide a peculiar effect unachievable by a conductor paste (for example, noble metal-base paste such as silver and gold) which is consistently fired in an oxidation atmosphere.

The average particle size of the SiO₂ fine particle is preferably 50 nm or less, more preferably 40 nm, still more preferably 30 nm or less, because if the average particle size exceeds 50 nm, warping or waving is readily generated on the wiring board and this is not preferred. The lower limit of the average particle size of the SiO₂ fine particle is not limited, but preferably, 5nm.

The SiO₂ fine particle is preferably not hydrophobed but has a hydrophilic surface, because if hydrophobed, the decomposability of organic components contained in the copper paste is worsened.

The amount of the SiO₂ fine particle added is preferably from 0.1 to 5.0 parts by mass (weight) per 100 parts by mass of the copper powder, more preferably, from 0.5 to 2.0 parts by mass per 100 parts by mass of the copper powder, because if the amount added is no less than 0.1 part by mass, warping or waving is not readily generated on the wiring board, whereas if it is no more than 5.0 parts by mass, the plating or soldering property of conductor is not impaired.

The copper paste comprising a copper powder, an organic vehicle and a ceramic particle having an average particle size of 100 nm or less and non-vitrifiable after sintering provides an operational effect that when this copper paste is coated on a ceramic green sheet and fired, a conductor layer prevented from the coming up of glass to the surface is formed and a wiring board reduced in the waving or warping and enabled to form a plating film with less defects on a wiring pattern can be obtained.

In general, it is considered that the copper working out to a conductor layer is enhanced in the sinterability due to, for example, a vitrifiable component contained in the copper paste or a vitreous component contained in the ceramic green sheet and diffused in the copper at the firing and thereby a dense conductor layer having low resistance is formed in the wiring board. As the copper is densified, the above-described vitreous component is deemed to come up to the conductor layer surface to deteriorate the plating property.

However, according to the copper paste of the present invention, the ceramic particle non-vitrifiable after sintering contained in the copper paste does not have fluidity unlike glass and therefore, the ceramic particle is uniformly dispersed in the conductor layer and does not come up to the conductor layer surface in the sintering process of copper at the firing step. That is, the conductor layer can have excellent plating property.

Furthermore, the average particle size of the ceramic particle is 100 nm or less and therefore, even if this ceramic particle comes adjacent or is exposed to the conductor layer surface, the plating property of the conductor layer is not impaired.

The ceramic particle non-vitrifiable after sintering as used in the present invention means a crystalline ceramic which is not vitrified by reacting with additives contained in the ceramic green sheet or copper paste.

The non-vitrifiable ceramic particle is selected from those containing at least one member of Al₂O₃, TiO₂, CeO₂ and mullite. More specifically, the construction material is appropriately selected by individually taking care not to react with additives contained in the ceramic green sheet or copper paste. In particular, TiO₂ is preferred because the waving amount of wiring board can be reduced and the adhesion strength of conductor layer is more increased.

The average particle size of the ceramic particle is preferably 100 nm or less, more preferably 50 nm or less, because if it no more than 100 nm, the cases that the wiring board is greatly waved after firing or that the conductor layer may is deteriorated in the plating property can be prevented. The lower limit of the average particle size of the ceramic particle is not limited, but preferably 5nm.

The amount of the ceramic particle is preferably from 0.1 to 5.0 part by mass, more preferably from 0.2 to 2.0 part by mass, per 100 parts by mass of the copper powder, because if the amount added is no less than 0.1 part by mass, the plating property of conductor layer does not deteriorate, whereas if it is no more than 5 parts by mass, the sinterability of copper does not deteriorate and the conductor resistance become small.

The copper paste preferably further comprises a vitreous ceramic particle or a ceramic particle vitrifiable after sintering (a second aspect of the invention).

According to the second aspect, a vitrifiable ceramic particle and a non-vitrifiable ceramic particle both are contained and therefore, even if glass is formed by the vitrifiable ceramic particle at the firing, the coming up of glass is prevented by the non-vitrifiable ceramic particle, as a result, the glass does not come up to the conductor layer surface and a conductor layer having excellent plating property can be obtained. Furthermore, the vitrifiable ceramic particle contained provides an operational effect that a wiring board reduced in the warping or waving can be obtained.

The vitreous ceramic particle of ruse in the present invention is amorphous SiO₂, glass flit or the like.

The ceramic particle vitrifiable after sintering for use in the present invention is a ceramic particle which is fired and thereby melted into the glass contained in the ceramic green sheet. Examples thereof include glass-forming oxides such as crystalline SiO₂ and B₂O₃, and oxides of alkali metals and alkaline earth metals, such as MgO, CaO, Na₂O and K₂O.

In the copper paste of the present invention, the average particle size of the copper powder is preferably from 0.5 to 10 µm, more preferably from 1 to 7 µm, still more preferably from 2 to 5 µm, because if the average particle size of the copper powder is no less than 0.5 µm, the case that the sintering initiation temperature of copper excessively decreases and warping or waving is sometimes generated on the wiring board can be prevented, whereas if the average particle size of the copper powder is no more than 10 µm, a fine wiring pattern is not difficult to form on the wiring board. The copper powder may have any shape such as nearly spherical, dendritic or flake form.

The copper paste is preferably free from an alkali metal or alkaline earth metal compound, because if an alkali metal or alkaline earth metal compound is contained, the wiring board is impaired in the electrical properties such as dielectric loss.

The copper paste preferably contains no glass flit, because if a glass flit is contained, glass remains on the conductor layer surface after firing and this impairs the plating or soldering property.

The organic vehicle is obtained by dissolving an organic polymer in an organic solvent and at least one organic polymer such as ethyl cellulose, acrylic resin, polymethylstyrene, butyral resin, PTFE, alkyd resin and polyalkylene carbonate is used therefor. In particular, an acrylic resin is preferred, and poly-n-butyl methacrylate and poly-2-ethylhexyl methacrylate are more preferred, because the decomposability at the firing is enhanced and a dense conductor layer having low resistance can be obtained.

The organic solvent is preferably a high boiling point solvent such as terpineol, butylcarbitol acetate, butylcarbitol and dibutyl phthalate.

In the copper paste of the present invention, components such as plasticizer, thickening agent, leveling agent and defoaming agent may also be contained.

A third aspect of the invention is a wiring board obtained by coating the copper paste of the first or second aspect on a ceramic green sheet and firing it to form a conductor layer and an insulating layer.

In the wiring board of the present invention, a copper paste having excellent sinterability is used and this provides an operational effect that the resistance value of conductor layer is low, a fine wiring pattern can be obtained and deformation such as warping or waving less occurs at the firing.

A wiring board obtained by coating a copper paste comprising a copper powder, an organic vehicle and a ceramic particle having an average particle size of 100 nm or less and non-vitrifiable after sintering as a conductor layer on a ceramic green sheet and firing it to form a conductor layer having dispersed in the thickness portion thereof an inorganic material having an average particle size of 2 µm or less (a fourth aspect of the invention). The inorganic material as used herein means a ceramic particle non-vitrifiable after sintering described in the first aspect, an inorganic component diffused from the insulating layer, a vitreous ceramic particle or a ceramic particle vitrifiable after sintering described in the second aspect, or an aggregate thereof.

According to the wiring board of the fourth aspect, an inorganic material having an average particle size of 2 µm or less is dispersed in the conductor layer and this provides an operational effect that the waving of the wiring board can be reduced, the inorganic material does not come up to the conductor layer surface and therefore, good plating can be performed.

Furthermore, in the wiring board of the fourth aspect, an inorganic material having an average particle size of 2 µm or less is dispersed in the conductor layer and this provides an operational effect that the conductor layer is densely sintered, a resistivity as low as 3×10⁻⁶ Ω•cm or less is obtained and in the wiring board of transmitting a high-frequency signal of 10 GHz band or more, the transmission loss can be decreased.

A fifth aspect of the invention is the wiring board obtained by coating a copper paste comprising a copper powder, an organic vehicle and an SiO₂ fine particle having an average particle size of 50 nm or less on a ceramic green sheet and firing it to form a conductor layer and an insulating layer, wherein the conductor layer has a resistivity of 3×10⁻⁶ Ω•cm or less.

According to the wiring board of the fifth aspect, the resistance value is 3×10⁻⁶ Ω•cm or less by virtue of the densely sintered conductor layer and this provides an operational effect that in the wiring board of transmitting a high-frequency signal of 10 GHz band or more, the transmission loss can be reduced.

A sixth aspect of the invention is the wiring board of the third aspect, the fourth aspect or the fifth aspect, wherein the alkali metal content in the insulating layer is 0.5 mol% or less in terms of oxide.

According to the wiring board of the sixth aspect, there is provided an operational effect that the wiring board is not impaired in the electrical properties such as dielectric loss and can have stable electrical properties in a high-frequency band region. In particular, by specifying the alkali metal content to 0.5 mol% or less in terms of oxide, the dielectric loss in the transmission signal of 10 GHz is reduced to 0.003 or less and a wiring board having excellent high-frequency properties can be obtained.

Furthermore, by specifying the alkali metal content to 0.2 mol% or less or 0.3 mol% or less in terms of oxide, the dielectric loss can be reduced to 0.0015 or less or 0.002 or less and a wiring board having excellent frequency properties can be obtained.

A surface of the conductor layer of the invention is preferably subjected to a plating treatment (a seventh aspect of the invention).

The wiring board of the seventh aspect provides an operational effect that a fine wiring pattern can be obtained by plating and at the same time, a wiring pattern having low resistance and reduced in the surface roughness can be formed, therefore, when a strip line (particularly microwave strip line) for forming a high-frequency circuit is formed, the signal transmission loss is reduced and high reliability is attained. For example, even when the conductor layer width is 100 µm or less, furthermore, 50 µm or less or 70 µm or less, a good plating film can be obtained.

The plating treatment as used in the present invention means a treatment of applying, for example, Ni plating on a conductor layer and further thereon Au plating, or a treatment of applying metal plating by using a metal species having low resistance, such as Cu plating.

The wiring board preferably comprises a conductor layer having dispersed in the inside thereof an inorganic material having an average particle size of 2 µm or less (an eighth aspect of the invention).

According to the wiring board of the eighth aspect, an inorganic material having an average particle size of 2 µm or less is dispersed in the conductor layer and this provides an operational effect that the waving of the wiring board can be reduced, the inorganic material does not come up to the conductor layer surface and therefore, good plating can be performed.

Furthermore, in the wiring board of the eighth aspect, an inorganic material having an average particle size of 2 µm or less is dispersed in the conductor layer and this provides an operational effect that the conductor layer is densely sintered, a resistivity as low as 3×10⁻⁶ Ω•cm or less is obtained and in the wiring board of transmitting a high-frequency signal of 10 GHz band or more, the transmission loss can be decreased.

An ninth aspect of the invention is a wiring board comprising a conductor layer having dispersed in the inside thereof an inorganic material, wherein in the cross section in the thickness direction of the conductor layer, the total area of the inorganic material having a particle size of 2 µm or more is 5% or less of the sectional area of the conductor layer.

According to the wiring board of the ninth aspect, in the cross section in the thickness direction of the conductor layer, the total area of the inorganic material having a particle size of 2 µm or more dispersed in the inside of the conductor layer is 5% or less of the sectional area of the conductor layer and this provides an operational effect that the waving of wiring board and the coming up of inorganic material to the conductor layer surface can be reduced and therefore, a good plating treatment can be performed.

Furthermore, in the wiring board of the present invention, the conductor layer is densely sintered and the resistivity is as low as 3×10⁻⁶ Ω•cm or less and this provides an operational effect that in the wiring board of transmitting a high-frequency signal of 10 GHz band or more, the transmission loss can be decreased.

A tenth aspect of the invention of is a wiring board comprising a conductor layer having dispersed in the inside thereof an inorganic material, wherein in the cross section in the thickness direction of the conductor layer, the total area of the inorganic material having a particle size of 3 µm or more is 2% or less of the sectional area of said conductor layer.

According to the wiring board of tenth aspect, in the cross section in the thickness direction of the conductor layer, the total area of the inorganic material having a particle size of 3 µm or more dispersed in the inside of the conductor layer is 2% or less of the sectional area of the conductor layer and this provides an operational effect that the waving of wiring board and the coming up of inorganic material to the conductor layer surface can be reduced and therefore, a good plating treatment can be performed.

Furthermore, in the wiring board of the present invention, the conductor layer is densely sintered and the resistivity is as low as 3×10⁻⁶ Ω•cm or less and this provides an operational effect that in the wiring board of transmitting a high-frequency signal of 10 GHz band or more, the transmission loss can be decreased.

An eleventh aspect of the invention is the wiring boards of the eighth to tenth aspects, wherein the surface of the conductor layer is subjected to a plating treatment.

The wiring board of the eleventh aspect provides an operational effect that a fine wiring pattern can be obtained by plating and at the same time, a wiring pattern having low resistance and reduced in the surface roughness can be formed, therefore, when a strip line (particularly microwave strip line) for forming a high-frequency circuit is formed, the signal transmission loss is reduced and high reliability is attained. For example, even when the conductor layer width is 100 µm or less, furthermore, 50 µm or less or 70 µm or less, a good plating film can be obtained.

The plating treatment as used in the present invention means a treatment of applying, for example, Ni plating on a conductor layer and further thereon Au plating, or a treatment of applying metal plating by using a metal species having low resistance, such as Cu plating.

A twelfth aspect of the invention is a method for producing a wiring board, comprising producing the wiring board of any one of the third to eleventh aspects by using the copper paste of the first or second aspect, wherein a ceramic green sheet coated with the copper paste is subjected to removal of organic components in a wet nitrogen atmosphere at 650 to 900°C (debindering step) and then fired at 850 to 1,050°C. The temperature at the debindering step is set in the range not exceeding the temperature at the subsequent firing.

First, organic components contained in the ceramic green sheet and copper paste are removed in wet nitrogen at 650 to 900°C (debindering step). Here, the temperature at the debindering step is set in the range not exceeding the temperature at the subsequent firing. The debindering is performed in the state such that the SiO₂ fine particle is dispersed in the periphery of the copper powder in the copper paste, therefore, the sintering initiation of copper powder is suppressed during debindering. However, in the subsequent firing step at a high temperature, the sintering of copper powder is accelerated due to exposure to wet nitrogen at the debindering and a dense conductor layer can be obtained.

In the firing process subsequent to the debindering step, the copper and the ceramic green sheet are simultaneously fired in nitrogen or wet nitrogen at 850 to 1,050°C. The sintering initiation temperature and sintering shrinkage timing each is controlled to approximate between copper and ceramic green sheet and this provides an operational effect that a wiring board free of warping or waving, favored with denseness and low resistance and reduced in the transmission loss of high-frequency signal can be obtained.

### BRIEF DESCRIPTION OF THE DRAWINGS

### [Fig. 1]

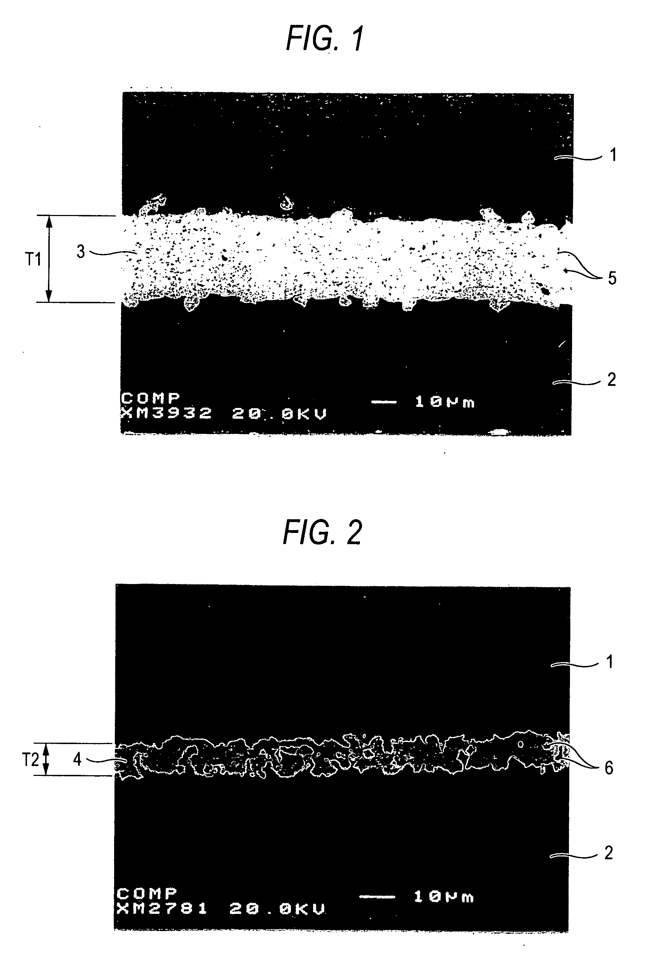

Fig. 1 is a cross-sectional photographic view when the cut face of a wiring board according to the embodiment of the present invention is observed by SEM (scanning-type electron microscope).

### [Fig. 2]

Fig. 2 is a cross-sectional photographic view when the cut face of a wiring board of Comparative Example is observed by SEM (scanning-type electron microscope).

### [Fig. 3]

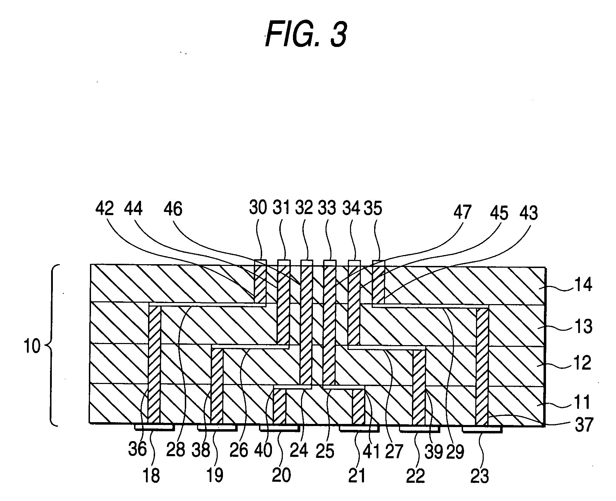

Fig. 3 is a cross-sectional view showing the structure of a wiring board according to one embodiment, to which the present invention is applied.

### [Description of Numerical References]

1 and 2: ceramic porcelain, 3 and 4: conductor layer, and 5 and 6: inorganic material.

### DETAILED DESCRIPTION OF THE INVENTION

### (Embodiment 1)

The inventions of the present invention are described below by referring to one embodiment.

### (1) Production of Ceramic Green Sheet

An alumina and glass mixed powder having a particle size of 2.5 µm and an alkali metal impurity content of 0.2 mol% or less was prepared by mixing 50 parts by mass of an alumina filler with 50 parts by mass of a glass powder having a composition such that SiO₂ was 31.65 parts by mass, B₂O₃ was 12.05 parts by mass, Al₂O₃ was 2.85 parts by mass and CaO was 3.45 parts by mass.

Thereafter, 20 parts by mass of a binder comprising acrylic resin, 10 parts by mass of a plasticizer comprising dibutyl phthalate and an appropriate amount of a toluene-MEK mixed solvent were added per 100 parts by mass of the alumina and glass mixed powder to prepare a slurry.

The obtained slurry was formed into a ceramic green sheet having a thickness of 250 µm by a sheet formation method such as doctor blade method. This ceramic green sheet is a low-temperature firing green sheet which can be fired at a relatively low temperature (1,000°C here).

### (2) Production of Copper Paste

Thereafter, 25 parts by mass of a vehicle and an additive shown in Table 1 were added to 100 parts by mass of a copper powder having an average particle size of 5 µm and these were mixed by a three-roll mill to produce a copper paste. Incidentally, the vehicle was prepared by dissolving 30 parts by mass of polyisobutyl methacrylate in 70 parts by mass of terpineol.

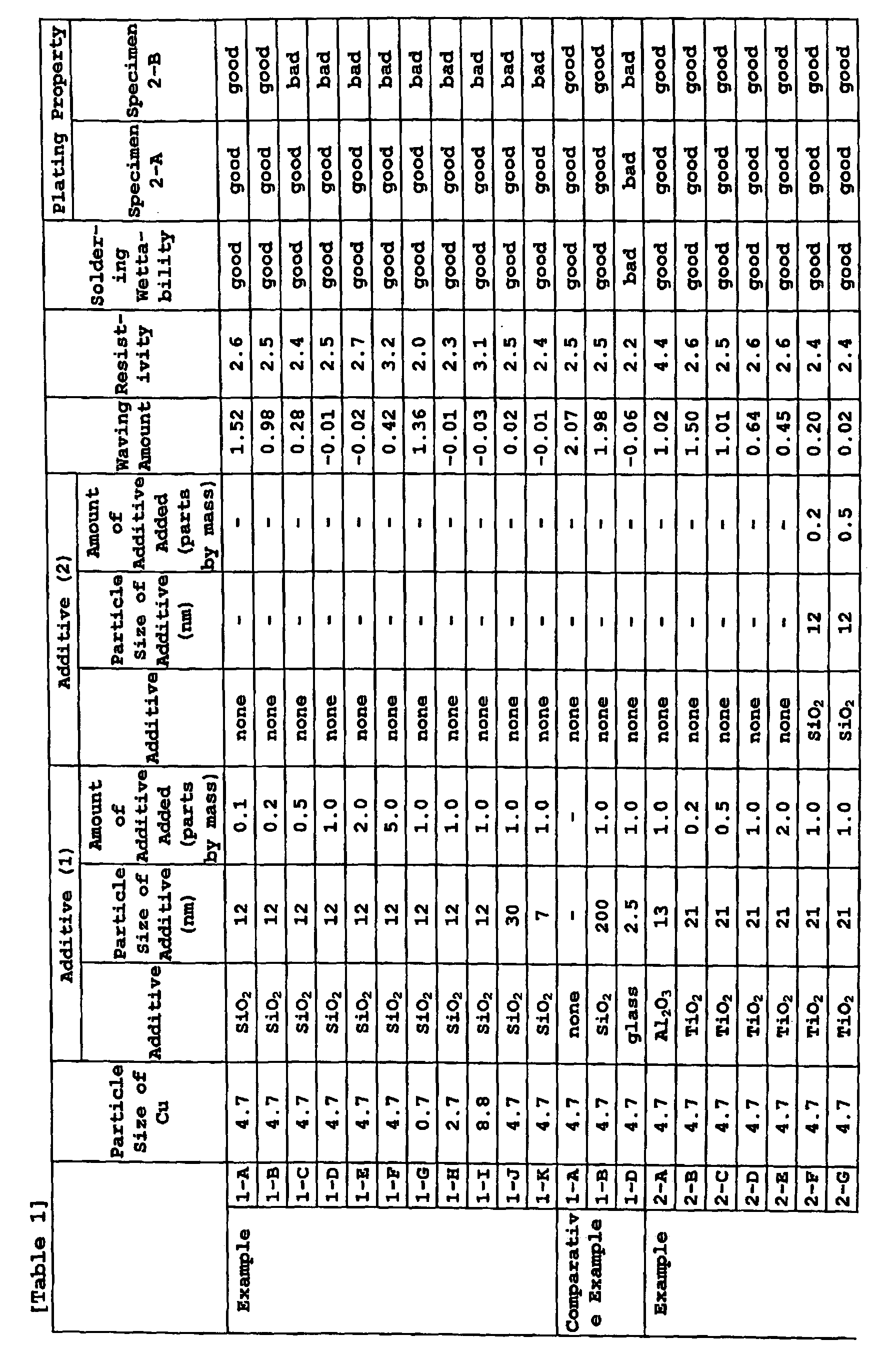

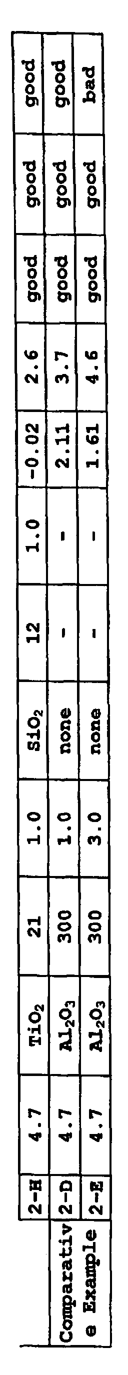

As shown in Table 1, copper pastes having the compositions of Examples 1-A to 1-K and 2-A to 2-H were produced as Examples of the present invention and also, copper pastes having the compositions of Comparative Examples 1-A, 1-B, 1-D, 2-D and 2-E were produced for comparison with the effect of the present invention.

Examples 1-A to 1-F were copper pastes where SiO₂ having a particle size of 12 nm was added to a copper powder having a particle size of 4.7 µm and the amount of SiO₂ added was changed in the range from 0.1 to 5.0 parts by mass.

Examples 1-G to 1-I were copper pastes where 1.0 part by mass of SiO₂ having a particle size of 12 nm was added to a copper powder having a particle size of 0.7 µm, 2.7 µm or 8.8 µm.

Examples 1-J and 1-K were copper pastes where 1.0 part by mass of SiO₂ was added to a copper powder having a particle size of 4.7 µm and the particle size of SiO₂ was 7 nm or 30 nm.

Comparative Example 1-A was a copper paste where a copper powder having a particle size of 4.7 µm was used and an additive was not added, Comparative Example 1-B was a copper paste where SiO₂ having a particle size of 200 nm was added to a copper powder having a particle size of 4.7 µm, and Comparative Example 1-D was a copper paste where 1.0 part by mass of glass having a particle size of 2.5 µm was added to a copper powder having a particle size of 4.7 µm.

Example 2-A was a copper paste where 1.0 part by mass of Al₂O₃ having an average particle size of 13 m was added to the copper powder.

Examples 2-B, 2-C, 2-D and 2-E were copper pastes where TiO₂ having an average particle size of 21 nm was added to the copper powder by changing the amount added in the range from 0.5 to 2.0 parts by mass.

Examples 2-F, 2-G and 2-H were copper pastes where 1.0 part by mass of TiO₂ having an average particle size of 21 nm was added to the copper powder and further, SiO₂ was added by changing the amount added in the range from 0.2 to 1.0 part by mass.

Comparative Examples 2-D and 2-E were copper pastes where Al₂O₃ having an average particle size of 300 nm was added in an amount of 1.0 part by mass or 3.0 parts by mass.

### (3) Production of Wiring Board

Using the thus-obtained green sheet and copper pastes, wiring boards as the sample for evaluation were produced.

First, the ceramic green sheet was cut into a dimension of 50 mm (length) × 60 mm (width) to prepare ceramic green sheet strips and Specimens 1-A and 2-A where the copper paste was printed to a dimension of 15 mm (length) × 15 mm (width) × 20 µm (thickness) on the nearly center part of the ceramic green sheet strip and Specimens 1-B and 2-B where the copper paste was printed to a dimension of 0.2 mm (width), 57 mm (length) and 20 µm (thickness) in the center on the top surface of the ceramic green sheet strip were produced.

Specimens 1-A, 2-A, 1-B and 2-B each was exposed in a furnace having prepared therein a mixed atmosphere of water vapor and nitrogen gas and left standing at a temperature of 850°C for 9 hours to degrease the organic components contained in the copper paste and ceramic green sheet. After displacement with a dry nitrogen gas, the temperature was elevated to 1,000°C and each specimen was left standing for 2 hours and thereby fired to produce a wiring board.

The waving amount of the wiring board produced by using Specimen 1-A was measured. In the measurement of waving amount, the maximum convex/concave amount in the portions printed or not printed with the copper paste of the wiring board was measured. The shape convexed in the direction toward the plane having a copper pattern of the wiring board is shown with a mark "+" and the shape convexed in the direction toward the plane not having a copper pattern of the wiring board is shown with a mark "-". The results obtained are shown in Table 1. Furthermore, Ni was plated on the Cu pattern of Specimen 1-A, Au was further plated on the top surface of Ni plating, the wiring board was dipped in a soldering layer having a eutectic point of 260°C, the soldered area was observed and the soldering wettability was compared and evaluated. The soldering wettability was rated good when the soldered area was 95% or more, and rated bad when the soldered area was less than 95%.

Also, the wiring board produced by using Specimen 1-B was determined on the resistivity by measuring the width, thickness, length and resistance value per predetermined length of the copper pattern. The results obtained are shown in Table 1.

### (4) Evaluation of Plating Property

Furthermore, Ni was plated to a thickness of 4 µm on the conductor layer surface of Specimens 2-A and 2-B by using an electroless plating method and further thereon, Au was plated to a thickness of 0.5 µm by using an electroless plating method.

The Au plating surface was observed through a magnifier and the presence or absence of non-plated portion was examined. The plating property was rated good when the plated portion occupied 99% or more in the area of the conductor layer, and rated bad when less than 99%. The results obtained are shown in Table 1.

As seen from Table 1, in Examples 1-A to 1-K and 2-B to 2-H of the present invention, a wiring board reduced in the waving amount and favored with a low resistivity could be obtained, where the waving amount of wiring board was from -0.03 to +1.52 mm and the resistivity was from 2.0 to 3.2 Ω•cm. In Example 2-A of the present invention, a wiring board reduced in the waving amount could be obtained, where the waving amount of wiring board was 1.02 mm.

In Comparative Example 1-A, when compared with Examples 1-A to 1-F of the present invention, the particle size of copper powder was 4.7 µm and equal to that of the present invention but SiO₂ as an additive was not added, as a result, the waving amount of the circuit board was as large as +2.07 mm.

In Comparative Example 1-B, when compared with Example 1-D of the present invention, the particle size of copper powder was 4.7 µm and equal to that in Example 1-D of the present invention but the particle size of SiO₂ was 200 nm and lager than the particle size (12 nm) in Example 1-D of the present invention, as a result, the waving amount of the wiring board was as large as +1.98 mm. The particle size of SiO₂ is preferably 50 nm or less.

In Comparative Example 1-D, when compared with Example 1-D of the present invention, the particle size of copper powder was 4.7 µm and equal to that in Example 1-D of the present invention but in place of SiO₂, the same amount of glass was added as the additive, as a result, despite the waving amount and resistivity almost equal to those in Example 1-D of the present invention, glass came up to the conductor layer surface to deteriorate the soldering wettability and the plating or soldering property was impaired.

Among Examples of the present invention, in Examples 1-C, 1-D and 1-E, the waving amount of the wiring board was as small as +0.28 mm to -0.02 mm and the resistivity was in the same level as that of other Examples, revealing that the amount of SiO₂ added is preferably from 0.5 to 2.0 parts by mass.

As seen from Table 1, in Examples 1-A, 1-B and 2-A to 2-H of the present invention, a wiring board reduced in the waving amount and favored with good plating property could be obtained, where the waving amount of wiring board was from -0.02 to +1.52 mm.

When Comparative Example 1-A is compared with Examples 2-A to 2-H of the present invention, in Comparative Example 1-A, an additive was not added and therefore, despite good plating property of the conductor layer, the waving amount of the circuit board was as large as 2.07 mm.

In Comparative Example 1-D, glass was added as the additive and therefore, the waving of wiring board was reduced, but the plating property of wiring board was bad.

When Comparative Example 2-D is compared with Example 2-A of the present invention, in Comparative Example 2-D, Al₂O₃ having a large particle size of 300 nm was added as the additive, as a result, the waving amount of the wiring board was as large as 2.11 mm.

When Comparative Example 2-E is compared with Example 2-A of the present invention, in Comparative Example 2-E, the wiring pattern plating property was deteriorated and this reveals that when a ceramic particle having a large particle size is added in a large amount, the fine wiring pattern plating property deteriorates.

When Example 2-A and Example 2-D of the present invention are compared, the amount of Al₂O₃ added in Example 2-A was 1.0 part by mass and the same as the amount of TiO₂ added in Example 2-D but the waving amount was more reduced in Example 2-D and this reveals that TiO₂ is preferably added so as to reduce the waving amount of the wiring board.

When Example 2-A of the present invention is compared with Examples 2-F, 2-G and 2-H of the present invention, it is seen that when TiO₂ is added as the additive and further SiO₂ is added, the waving amount of the wiring board can be more reduced.

### (Embodiment 2)

Using the ceramic green sheet produced in Embodiment 1 and the copper paste having the composition of Example 1-I of Embodiment 1, a conductor pattern was printed on the ceramic green sheet. A plurality of these sheets were stacked and pressed to produce a green sheet stacked body.

This green sheet stacked body was exposed in a furnace having prepared therein a mixed atmosphere of water vapor and nitrogen gas, left standing and thereby degreased at a temperature of 850°C, and then left standing and thereby fired at a temperature of 1,000°C for 2 hours.

Thereafter, Ni was plated on the conductor layer exposed to the top surface of this wiring board and Au was further plated on the top face of Ni to produce a wiring board.

The obtained wiring board exhibited low transmission loss even for a high-frequency signal of 10 to 40 GHz, revealing that a wiring board having excellent high-frequency properties was obtained. Furthermore, the conductor layer having a width of tens of microns formed on the wiring board was enlarged and observed by a microscope, as a result, plating unevenness was not present, revealing that a high-precision pattern was obtained.

### [Reference Test for Verifying Effects of the Present Invention]

The shrinkage percentage was compared between the copper paste in Example of the present invention and the copper paste in Comparative Examples and the results were used as the basis for verifying the effect of the present invention.

As shown in Table 2, mixed powders of copper and additive used in Example 1-D and 2-A and Comparative Examples 1-A of Table 1 were prepared. Each mixed powder was uniaxially formed and then subjected to cold hydrostatic formation by applying a pressure of 150 MPA to obtain a rectangular parallelopiped shaped article mainly comprising copper and having a size of 3×3×18 mm.

In a nitrogen atmosphere, each shaped article was heated from 20°C to 1,000°C at a temperature rising rate of 10°C/min and the shrinkage percentage was measured by using TMA (thermomechanical analyzer). The results obtained are shown in Table 2.

**[Table 2]**

| | Composition of Cu Shaped Article | | | | Shrinkage percentage (%) |
|---|---|---|---|---|---|
| | Particle Size of Cu (µm) | Additive | Particle Size of Additive | Amount of Additive Added (parts by mass) | |
| Example 1-D | 4.7 | SiO₂ | 12 nm | 1.0 | 5.10 |
| Comparative Example 1-A | 4.7 | none | none | none | 2.69 |
| Example 2-A | 4.7 | Al₂O₃ | 13 nm | 1.0 | 5.86 |

As seen in Table 2, the shrinkage percentage was almost the same in Examples 1-D and Example 2-A and most small in Comparative Example 1-A. However, when the conductor part of a wiring board produced according to the embodiment was observed by SEM (scanning-type electron microscope), the conductor part of Example 1-D of the present invention was densified as compared with those of Comparative Examples 1-A.

This reveals that when a wiring board is produced by using the copper paste of the present invention, irrespective of large or small shrinkage percentage, the sinterability of conductor layer (copper) is remarkably enhanced.

The operational effects of the copper paste, wiring board and production method thereof according to the embodiment of the present invention having the above-described constitutions are described below.

When the copper paste according to the embodiment of the present invention is printed on a ceramic green sheet, once exposed in a wet nitrogen atmosphere and then fired, a dense conductor layer is formed and a wiring board having a small resistance value and reduced in the warping or waving can be obtained.

In the wiring board according to the embodiment of the present invention, the resistivity is 3×10⁻⁶ Ω•cm or less by virtue of the densely sintered conductor layer and therefore, the transmission loss can be reduced even when used as a wiring board of transmitting a high-frequency signal of 10 GHz band or more.

The wiring board according to the present invention exhibits stable electric properties in a high-frequency band region without impairing the electric properties such as dielectric loss. Particularly, the dielectric loss at 10 GHz is 0.003 or less and the high-frequency properties are excellent.

In the production method of a wiring board according to the embodiment of the present invention, the sintering of copper is accelerated and dense sintering is attained, so that a wiring board having a small resistance value and reduced in the transmission loss of high-frequency signal can be obtained.

In the embodiment of the present invention, the copper paste does not contain a glass flit, however, according to the pattern design of wiring board, a slight amount of glass may be contained to an extent of not impairing the soldering or plating property.

In the embodiment of the present invention, Ni is plated on the top face of copper as the conductor layer and Au is further plated on the top face of Ni plating, however, other metal having a low resistance may be plated on the top face of copper.

In the wiring board of the present invention, the conductor layer is low in the resistivity and stable in the electric properties and therefore, this wiring board is preferably used as a semiconductor element housing package by enclosing a semiconductor element in the wiring board.

### (Embodiment 3)

Using the copper pastes of Example 2-G and Comparative Example 2-E produced in Embodiment 1, a conductor pattern was printed on the ceramic green sheet. A plurality of these sheets were stacked and pressed to produce a green sheet stacked body.

This green sheet stacked body was exposed in a furnace having prepared therein a mixed atmosphere of water vapor and nitrogen gas, left standing and thereby degreased at a temperature of 850°C, and then left standing and thereby fired at a temperature of 1,000°C for 2 hours to produce a wiring board.

Thereafter, the wiring board was cut, the cut face was polished, the cross section of conductor layer was observed by SEM (scanning-type electron microscope) and an enlarged photograph was taken and shown as Figs. 1 and 2.

Fig. 1 is a cross-sectional photographic view of a wiring board using the copper paste of Example 2-G and Fig. 2 is a cross-sectional photographic view of a wiring board using the copper paste of Comparative Example 2-E.

In Figs. 1 and 2, 1 and 2 are a ceramic porcelain, T1 and T2 are a thickness range of conductor layers 3 and 4, and an inorganic material 5 or 6 comprising TiO₂ or SiO₂ is dispersed inside the conductor layers 3 and 4.

According to the copper paste of Example 2-G of the present invention, as seen in Fig. 1, an inorganic material 5 is uniformly dispersed (dispersed at an average interval of 1.5 µm) in the thickness range T1 of the conductor layer 3.

Furthermore, the ceramic porcelain 1 or 2 and the conductor layer 3 are almost smoothly bonded at respective interfaces of the conductor layer and the ceramic porcelain 1 or 2 and the firing is attained without causing ingrowth of the ceramic porcelain 1 or 2 into the conductor layer 3.

On the other hand, according to the copper paste of Comparative Example 2-E, as seen in Fig. 2, a relatively large inorganic material 6 reaching a few µm is contained in the thickness range T2 of the conductor layer 4 and ingrowth of ceramic porcelain into the conductor layer 4 is observed at respective interfaces of the conductor layer 4 and the ceramic porcelain 1 or 2.

Also, in the wiring board using the copper paste of Comparative Example 2-E, a large inorganic material of about 5 µm is observed on the surface and this inorganic material abundantly and continuously appears on the surface of the conductor layer 4.

As such, in Example 2-G of the present invention, the inorganic material 5 is uniformly dispersed in the thickness range T1 of the conductor layer 3 as compared with Comparative Example 2-E and this reveals that the inorganic material less comes up to the wiring board surface and excellent plating property is ensured.

Furthermore, a smooth conductor layer 3 is obtained without causing ingrowth of the ceramic porcelain 1 or 2 into the thickness range T1 of the conductor layer 3 and this reveals that the conductor resistance is low and a wine wiring pattern can be formed.

The inorganic material dispersed in the conductor layer 3 of Example 2-G was analyzed by EPMA (electron probe microanalysis), as a result, Ca or Al as the glass component of the ceramic porcelain 2 was observed in addition to Ti or Si previously added in the copper paste. That is, the glass component such as Ca and Al was uniformly dispersed as an inorganic material in the conductor layer 3 and did not come up to the surface of the conductor layer 3, therefore, a conductor layer having excellent plating property was obtained. Also, the resistivity of the conductor layer 3 was measured and found to be 3×10⁻⁶ **Ω•cm** or less or 2.5×10⁻⁶ Ω•cm or less. Thus, good results were obtained.

### (Embodiment 4)

Using the wiring board of Example 2-G produced in Embodiment 3, Ni plating in a thickness of 4 µm was applied to the conductor layer on the top surface of the wiring board by an electroless plating method and further thereon, Au plating in a thickness of 0.5 µm was applied by an electroless plating method to produce a wiring board for high-frequency circuit having a fine wiring pattern.

The surface of the obtained wiring board was observed through a magnifier, as a result, it was found that the plating was successfully attached even on the fine conductor layer.

Thereafter, the wiring boards of Example 2-G and Comparative Example 2-E each was cut, the cut face was polished, the cross section of the conductor layer was observed by SEM (scanning-type electron microscope) and a reflection electron composition image was obtained. Based on the reflection electron composition image, inorganic materials having a particle size of 2 µm or more and 3 µm or more, present in an arbitrary sectional area of 4,000 µm² of the conductor layer were detected. In the reflection electron composition image, the bright part (white portion) shows heavy elements such as Cu and the dark part (black portion) shows the inorganic material. The ratio of the total area of the inorganic material (dark part) to the sectional area of the conductor layer was calculated by the image processing, as a result, in Example G, the ratio of the inorganic material having a particle size of 2 µm or more was 1.2% and the ratio of the inorganic material having a particle size of 3 µm or more was 0.7%. In Comparative Example E, the ratio of the inorganic material having a particle size of 2 µm or more was 6.1% and the ratio of the inorganic matter having a particle size of 3 µm or more was 2.5%.

Therefore, the total area of the inorganic matter having each particle size or more in the sectional area of the conductor layer was calculated and at the same time, the plating property on the conductor layer surface was evaluated. As a result, when the total area ratio of the inorganic material having each particle size or more to the sectional area of the conductor layer was 5% or less in the case of a particle size of 2 µm or more and 2% or less in the case of a particle size of 3 µm or more, the waving of wiring board and the coming up of the inorganic material to the conductor layer surface could be reduced and a good plating treatment could be performed. Furthermore, the resistivity of the conductor layer was 3×10⁻⁶Ω•cm or less and a good result was obtained.

### (Embodiment 5)

Using the copper paste of Example 2-G, a multilayer wiring board was produced by stacking a plurality of ceramic layers and a plurality of conductor layers.

In Fig. 3, a wiring board 10 is produced by printing a copper paste on surfaces of a plurality of ceramic green sheets each having formed therein a via hole, also filling the copper paste in the via hole, stacking these ceramic green sheets and subjecting the resulting laminate to degreasing and baking. In the wiring board 10, conductor layers 24 to 29 are formed on respective surfaces between superposed ceramic layers 11 to 14 and the conductor layers 24 to 29 are connected by via conductors 36 to 47. On the bottom surface of the ceramic layer 11, circuit terminals 18 to 23 are formed to connect with via conductors 36 to 41, respectively. These circuit terminals 18 to 23 are formed by printing a copper paste on respective exposed faces of via conductors 36 to 41, performing simultaneous firing, applying Ni plating to each conductor surface and then applying Au plating on each Ni plating surface. On the top surface of the ceramic layer 14, plating layers 30 to 35 are formed to connect with via conductors 42 to 47, respectively. These plating layers 30 to 35 are formed by applying Ni plating to respective exposed faces of via conductors 42 to 47 and applying Au plating on each Ni plating surface. Thereto, the terminal (not shown) of a semiconductor element is connected by soldering to lie over the plating layers 30 to 35.

As such, in the wiring board 10, the circuit terminals 18 to 23 on the bottom ceramic layer 11 are connected to the plating layers 30 to 35 on the top ceramic layer 14 through via conductors 36 to 47, conductor layers 24 to 29 and the like, and connected to the terminal of a circuit component (not shown) through the plating layers 30 to 35, thereby constituting an electrical circuit.

In the thus-obtained wiring board 10, conductor layers 24 to 29 free of coming up of glass to the surface are formed, waving or warping is reduced and a good plating film having no defect such as pinhole is formed even on a fine wiring pattern.

The operational effects of the copper paste and wiring board according to the embodiment of the present invention having the above-described constitutions are described below.

When the copper paste according to the embodiment of the present invention is printed on a ceramic green sheet and fired, a conductor layer free of coming up of glass to the surface is formed, the waving or warping is reduced and a good plating film having no defect such as pinhole can be formed on a fine wiring pattern.

When the copper paste according to the embodiment of the present invention is used, a wiring pattern having low resistance and reduced in the surface roughness can be formed and therefore, when a strip line (particularly microwave strip line) for forming a high-frequency circuit is formed, a wiring board decreased in the signal transmission loss and having high reliability can be obtained.

In the wiring board of the present invention, the resistivity is 3×10⁻⁶ Ω•cm or less by virtue of the densely sintered conductor layer and therefore, even in a wiring board of transmitting a high-frequency signal of 10 GHz band or more, the transmission loss can be decreased.

Furthermore, according to the wiring board using the copper paste of the present invention, a fine conductor layer can be formed and a good plating film having no defect such as pinhole can be formed on the fine conductor layer surface, therefore, the wiring board is suitably used for a package which encloses a semiconductor.

In the embodiment of the present invention, Ni is plated on the top face of copper constituting the conductor layer and Au is further plated thereon, however, other metal plating using a metal species having low resistance may be applied to the top face of copper.

This application is based on Japanese Patent application JP 2002-208319, filed July 17, 2002, and Japanese Patent application JP 2002-208321, filed July 17, 2002, the entire contents of those are hereby incorporated by reference, the same as if set forth at length.

## Claims

1. A wiring board obtained by coating a copper paste on a ceramic green sheet and firing it to form a conductor layer and an insulating layer, the copper paste comprising a copper powder, an organic vehicle and at least one selected from the group consisting of: an SiO₂ particle having an average particle size of 50 nm or less; and a ceramic particle having an average particle size of 100 nm or less and non-vitrifiable after sintering.

2. A wiring board obtained by coating a copper paste on a ceramic green sheet and firing it to form a conductor layer and an insulating layer, the copper paste comprising a copper powder, an organic vehicle and an SiO₂ particle having an average particle size of 50 nm or less.

3. A wiring board obtained by coating a copper paste on a ceramic green sheet and firing it to form a conductor layer and an insulating layer, the copper paste comprising a copper powder, an organic vehicle and a ceramic particle having an average particle size of 100 nm or less and non-vitrifiable after sintering.

4. The wiring board according to any one of claims 1 to 3, wherein the conductor layer has a resistivity of 3×10⁻⁶ Ω•cm or less.

5. The wiring board according to any one of claims 1 to 4, wherein the insulating layer comprises an alkali metal in amount of 0.5 mol% or less in terms of oxide.

6. The wiring board according to any one of claims 1 to 5, wherein the conductor layer comprises an inorganic material (5) having an average particle size of 2 µm or less, the inorganic material (5) being dispersed within the conductor layer so as not to be exposed to an outside of the conductor layer.

7. A wiring board comprising a conductor layer containing an inorganic material (6) dispersed within the conductor layer, wherein in a cross section in a thickness direction of the conductor layer, a total area of the inorganic material (6) having a particle size of 2 µm or more is 5% or less of the sectional area of the conductor layer.

8. A wiring board comprising a conductor layer containing an inorganic material (6) dispersed within the conductor layer, wherein in a cross section in a thickness direction of the conductor layer, a total area of the inorganic material (6) having a particle size of 3 µm or more is 2% or less of the sectional area of the conductor layer.

9. The wiring board according to any one of claims 1 to 8, wherein a surface of the conductor layer is subjected to a plating treatment.

10. A copper paste comprising a copper powder, an organic vehicle and at least one selected from the group consisting of: an SiO₂ particle having an average particle size of 50 nm or less; and a ceramic particle having an average particle size of 100 nm or less and non-vitrifiable after sintering.

11. The copper paste according to claim 10, wherein the SiO₂ particle is in an amount of 0.1 to 5.0 parts by mass per 100 parts by mass of the copper powder.

12. The copper paste according to claim 10 or 11, which further comprises a vitreous ceramic particle or a ceramic particle vitrifiable after sintering.

13. The copper paste according to any one of claims 10 to 12, which comprises more than 20 parts by mass of the organic vehicle per 100 parts by mass of the copper powder.

14. A method for producing a wiring board comprising the steps of:
coating the copper paste according to any one of claims 10 to 13 on a ceramic green sheet;
exposing the coated sheet to a wet nitrogen atmosphere at 650 to 900°C so as to remove organic components; and
firing the sheet at 850 to 1,050°C after the exposing.
